# EUROPÄISCHE PATENTANMELDUNG

(11) **EP 2 214 213 A2**
(43) Veröffentlichungstag der Anmeldung: **04.08.2010**
(21) Anmeldenummer: 10000499.3
(22) Anmeldetag: 20.01.2010
(51) Int. Cl.: H01L 31/0224

(54) **Photovoltaisches Modul**

(30) Priorität: 29.01.2009 DE 102009006720; 24.02.2009 DE 102009010262; 02.09.2009 DE 102009039750
(71) Anmelder: SCHOTT Solar AG, 55122 Mainz (DE)
(72) Erfinder: Knoll, Hartmut, Dr., 06749 Bitterfeld (DE); Lechner, Peter, 85591 Vaterstetten (DE); Weidl, Roland, Dr., 07646 Bollberg (DE); Heckel, Erwin, 84072 Au in der Hallertau (DE); Güldner, Ralf, 63739 Aschaffenburg (DE)
(74) Vertreter: Haft, von Puttkamer, Berngruber, Karakatsanis

(57) **Zusammenfassung**

Zum Befestigen des Kontaktbandes (8) an der Rückelektrodenschicht (4) eines photovoltaischen Moduls wird die Rückelektrodenschicht (4) an ihrer Außenseite mit einer Zinn-, Kupfer- und/oder Silber-haltigen Kontaktschicht (12) versehen. Anschließend wird das an der Fügefläche mit Lot (17) versehene Kontaktband (8) durch Löten mit der Rückelektrodenschicht (4) verbunden. Durch die Kontaktschicht (12) wird eine gute Haftung des Rückseitenverkapselungsmaterials (13) erreicht. Durch eine Sperrschicht (11) wird eine Legierung des Lötzinns mit den Schichten (9, 10) der Rückelektrodenschicht (4) verhindert.

## Beschreibung

Die Erfindung bezieht sich auf ein photovoltaisches Modul nach dem Oberbegriff des Anspruchs 1 sowie ein Verfahren zur Befestigung der Kontaktbänder an einem solchen Modul.

Um die durch Lichteinstrahlung erzeugten Ladungsträger abführen und deren Energie nutzen zu können, werden an der Rückelektrodenschicht einzelner Zellen des photovoltaischen Moduls Kontaktbänder befestigt. Die Kontaktierung der Kontaktbänder mit der Rückelektrodenschicht kann auf verschiedene Art und Weise durchgeführt werden, beispielsweise durch Kleben, Löten oder Schweißen. Dabei wird das Löten dem Kleben vorgezogen, weil es nicht nur zu einer stabileren mechanischen und elektrischen Verbindung führt, sondern auch verfahrenstechnisch wesentlich einfacher ist.

Wenn die Kontaktbänder durch eine Lötverbindung an der Rückelektrodenschicht befestigt werden sollen, muss die Fügefläche, also die abschließende Fläche der Rückelektrodenschicht aus einem lötbaren Material bestehen. Dazu weisen die bekannten photovoltaischen Module meist eine Nickel-Vanadium-Schicht auf der Rückelektrodenschicht auf.

Zwar kann dann mit bleihaltigen Loten eine Lötverbindung hergestellt werden, jedoch ist das Prozessfenster sehr klein, sodass schon kleine Schwankungen im Prozessablauf, beispielsweise Temperaturabweichungen oder geringe Abweichungen der Dicke der Lotschicht, zu fehlerhaften Lötstellen und damit fehlerhaften Modulen führen können, insbesondere bei Dünnschichtsolarmodulen. Bei Verwendung von bleifreiem Lot ist der Lötprozess noch weitaus schlechter kontrollierbar, sodass nahezu ausnahmslos fehlerhafte Module entstehen.

Im Hinblick auf die REACH-Verordnung und andere gesetzliche Bestimmungen zum Schutz der Gesundheit und Umwelt, durch die Blei aus photovoltaischen Modulen verbannt wird, ist die Verwendung von bleifreien Loten bei der Herstellung von photovoltaischen Modulen jedoch von besonders großen Interesse.

Aufgabe der Erfindung ist es, eine Lotverbindung zwischen der Rückelektrodenschicht und den Kontaktbändern eines photovoltaischen Moduls zur Verfügung zu stellen, welche sowohl mit einem bleifreien wie mit einem bleihaltigen Lot mit einem nicht zu engen Prozessfenster fehlerfrei hergestellt werden kann.

Dies wird erfindungsgemäß mit dem photovoltaischen Modul nach dem Anspruch 1 bzw. mit dem Verfahren nach dem Anspruch 17 erreicht. In den Unteransprüchen sind vorteilhafte Ausgestaltungen der Erfindung wiedergegeben.

Nach der Erfindung wird die Rückelektrodenschicht an ihrer Außenseite, also ihrer von der Lichteinfallseite des photovoltaischen Moduls abgewandten Rückseite, mit einer dünnen zinn-, kupfer- und/oder silberhaltigen Kontaktschicht versehen. Die Schichtdicke der Kontaktschicht beträgt normalerweise maximal 500 nm und vorzugsweise mindestens 1 nm. Besonders bevorzugt ist eine Schichtdicke der Kontaktschicht von mindestens 10 nm und höchstens 100 nm, insbesondere von 15 bis 50 nm.

An der so vorbehandelten zinn-, kupfer- und/oder silberhaltigen Kontaktschicht kann dann das Kontaktband durch Löten befestigt werden. Dazu ist das Kontaktband mindestens an seiner der Rückelektrodenschicht zugewandten Fügefläche mit einem Lot versehen, wodurch beim Löten zwischen dem Kontaktband und der Rückelektrodenschicht eine Lötverbindung hergestellt wird.

Die zinn-, kupfer- und/oder silberhaltige Kontaktschicht kann aus (unlegiertem) Zinn, Kupfer oder Silber bestehen oder aus einer Zinn-, Kupfer- oder Silberlegierung. Da insbesondere Zinn bzw. Zinnlegierungen an der Luft zumindest an der Oberfläche leicht oxidieren, kann die zinnhaltige Schicht auch in einer zumindest teilweise oxidierten Form vorliegen. Der Zinngehalt der zinnhaltigen Schicht beträgt vorzugsweise mindestens 10 Gew.-%, insbesondere mehr als 50 Gew.-%. In gleicher Weise beträgt der Kupfer- bzw. der Silbergehalt der kupfer- bzw. silberhaltigen Kontaktschicht vorzugsweise mindestens 10 Gew.-%, insbesondere mehr als 50 Gew.-% Kupfer bzw. Silber. Die Kupfer- und Silberlegierung kann ebenfalls zumindest teilweise oxidiert sein. Gleiches gilt für reines Kupfer und ggf. auch für reines Silber.

Die zinn-, kupfer- und/oder silberhaltige Schicht wird vorzugsweise durch ein PVD-Verfahren, also physikalische Gasphasenabscheidung aufgetragen, insbesondere durch Magnetron-Sputtern. Dabei kann das Zinn bzw. die Zinnlegierung reaktiv mit Sauerstoff als Zinnoxid (SnOₓ) gesputtert werden.

Die Rückelektrodenschicht weist eine oder mehrere Schichten aus Metall, beispielsweise aus Aluminium, Silber, Kupfer und/oder Chrom, auf. Die zinn-, kupfer- und/oder silberhaltige Kontaktschicht wird dann auf die Schicht aufgetragen, die auf der von der Halbleiterschicht abgewandten Seite der Solarzelle den Schichtaufbau der Rückelektrodenschicht abschließt. So kann die den Schichtaufbau der Rückelektrodenschicht abschließende Schicht beispielsweise eine Schutzschicht aus einer Nickel-Vanadium-Legierung oder Tellur sein.

Durch die erfindungsgemäße Kontaktschicht ist die Rückelektrodenschicht sehr gut lötbar. D.h. die Kontaktschicht erleichtert die Benetzbarkeit und damit die Lötbarkeit der Rückelektrodenschicht und zwar sowohl mit bleihaltigem als auch mit bleifreiem Lot. Dies führt zu einem stabileren und weniger fehleranfälligen Lötprozess. D.h. durch die bessere Benetzbarkeit der Rückelektrodenschicht muss zum Löten weniger Energie zugeführt werden, wodurch die Löttemperatur und/oder die Lötzeit herabgesetzt werden können. Durch die kürzeren Lötzeiten kann zudem die Prozesszeit reduziert werden. Nach der Erfindung kann auch mit bleifreiem Lot eine einwandfreie Lötverbindung hergestellt werden. Weiterhin wird der Prozess bei Verwendung von bleihaltigem Lot besser kontrollierbar.

Das Kontaktband weist normalerweise eine Breite von 1 bis 5 mm und eine Dicke von 20 bis 500 µm, insbesondere 50 bis 200 µm auf. Es besteht üblicherweise aus Metall, insbesondere Kupfer, Aluminium oder Silber oder aus einer Legierung dieser Metalle, ggf. auch aus Stahl.

Das Kontaktband ist zumindest an der der Rückelektrodenschicht zugewandten Fügefläche mit einer Lotschicht versehen. Normalerweise ist das Kontaktband jedoch am gesamten Umfang mit Lot beschichtet. Die Dicke der Lotschicht kann 5 bis 50 µm betragen, insbesondere 10 bis 30 µm. Das mit der Lotschicht versehene Kontaktband kann durch ein Tauchverfahren hergestellt werden, bei dem das Kontaktband kontinuierlich durch das geschmolzene Lot geführt wird.

Das Lot kann ein bleihaltiges oder ein bleifreies Weichlot sein. Das bleihaltige Lot kann beispielsweise aus bleihaltigem Lötzinn, also einer bleihaltigen Zinnlegierung bestehen, und das bleifreie Lötzinn eine bleifreie Zinnlegierung, insbesondere eine Legierung aus der Gruppe Zinn/Silber, Zinn/Kupfer oder Zinn/Silber/Kupfer sein.

Erfindungsgemäß kann jedes gängige Lötverfahren zur Anwendung kommen, um das Kontaktband mit der Rückelektrodenschicht zu verbinden. D.h. es kann beispielsweise das thermische Löten durch Kontakt mit einem Medium hoher Temperatur, das Ultraschall-Löten oder Laser-Löten durchgeführt werden. Besonders bevorzugt wird jedoch ein induktives Lötverfahren angewendet, bei dem das Kontaktband bestromt wird, insbesondere das induktive Hochfrequenz-Löten.

Das photovoltaische Modul kann aus Dünnschichtsolarzellen oder kristallinen Solarzellen basierend auf einem Halbleiter-Wafer aufgebaut sein.

Die Dünnschichtsolarzellen weisen auf der Lichteinfallsseite des Moduls ein transparentes, elektrisches nichtleitendes Substrat, beispielsweise eine Glasscheibe auf, auf der nacheinander eine Frontelektrodenschicht, wenigstens eine Halbleiterschicht und die Rückelektrodenschicht angeordnet sind. Die Einzelzellen des photovoltaischen Moduls sind normalerweise serienverschaltet. Dazu sind die Frontelektrodenschicht, die Halbleiterschicht und die Rückelektrodenschicht durch Trennlinien strukturiert. An der für die Stromabnahme vorgesehenen Einzelzelle wird dann das Kontaktband angelötet.

Die Frontelektrodenschicht des erfindungsgemäßen photovoltaischen Dünnschichtmoduls weist eine Dicke von z.B. 50 bis 100 nm auf und besteht vorzugsweise aus einem transparenten, elektrisch leitfähigen Metalloxid, insbesondere Zink- oder Zinnoxid, beispielsweise mit Aluminium dotiertem Zinkoxid, Indium-Zinnoxid oder z.B. mit Fluor dotiertem Zinnoxid. Die Halbleiterschicht kann aus amorphem, mikromorphem oder mikrokristallinem Silizium bestehen. Sie kann jedoch auch eine Verbundhalbleiterschicht sein, beispielsweise ein II-VI-Halbleiter wie Cadmium-Tellurid, ein III-V-Halbleiter wie Gallium-Arsenid oder ein I-III-VI-Halbleiter wie Kupfer-Indium-Diselenid.

Die Rückelektrodenschicht der Dünnschichtsolarzellen des erfindungsgemäßen Moduls weisen auf der der Halbleiterschicht zugewandten Seite vorzugsweise als Diffusionssperre und zur Verbesserung der Reflexionseigenschaften eine Zwischenschicht aus einem transparenten elektrisch leitfähigen Metalloxid auf, insbesondere Zinkoxid. Jedoch können auch andere transparente Metalloxide eingesetzt werden, beispielsweise Zinnoxid oder Indium-Zinnoxid.

Die Rückelektrodenschicht, die die Reflektorschicht umfasst, weist eine Schichtdicke von 100 bis 500 nm, insbesondere 200 bis 300 nm auf. Die metallische Reflektorschicht kann beispielsweise aus Aluminium, Silber, Kupfer und/oder Chrom oder einer Legierung dieser Metalle bestehen. Auch kann sie aus mehreren Teilschichten aus unterschiedlichen Materialien aufgebaut sein, beispielsweise einer der Halbleiterschicht zugewandten ersten Schicht aus Silber und einer darauf aufgebrachten Aluminiumschicht als zweite Schicht, um die Reflektorschicht zur Reflexion des auf die Rückelektrodenschicht einfallenden Lichts zu bilden, das von der Halbleiterschicht nicht absorbiert worden ist. Die Dicke der Reflektorschicht kann 50 bis 300 nm betragen.

Bei Solarmodulen beispielsweise auf der Basis von amorphem, mikromorphem oder mikrokristallinem Silizium oder Cadmium-Tellurid, aber auch einem kristallinen Wafer, wird zur Rückflächenverkapselung auf die Rückelektrodenschicht beispielsweise eine EVA-Einbettfolie mit einer Glasscheibe (sogenanntes Glas-Glas-Laminat) oder mit wenigstens einer weiteren Folie (sogenanntes Glas-Folie-Laminat) laminiert. Die Einbettfolie wird dabei direkt auf die Rückelektrodenschicht, die zuvor mit den Kontaktbändern durch Kleben oder Löten versehen worden ist, laminiert.

Die Einbettfolien, insbesondere eine EVA-Folie weist jedoch häufig keine zufrieden stellende Haftung an der Rückelektrodenschicht auf, sodass ein Primer verwendet werden muss. Der Einsatz von Primern ist jedoch kostspielig, aufwändig und ökologisch nicht unbedenklich. Bei manchen Einbettfolien, beispielsweise der schnellvernetzenden oder sogenannten "fast-cure"-EVA-Folie führt selbst ein Primer zu keiner befriedigenden Haftung.

Überaschenderweise hat sich herausgestellt, dass an der erfindungsgemäßen Kontaktschicht auch ohne Einsatz eines Primers eine gute Haftung des Rückflächenverkapselungsmaterials erreicht wird, und zwar auch mit einer schnellvernetzenden Einbettfolie.

Durch die erfindungsgemäße Zinn-, Kupfer- und/oder Silber-haltige Schicht der Solarzelle an der Grenzfläche zu dem Rückflächenverkapselungsmaterial können also einerseits die Kontaktbändchen durch Löten hervorragend befestigt werden, zum anderen wird eine ausgezeichnete Haftung des Rückflächenverkapselungsmaterials an der Rückelektrodenschicht erreicht, und zwar vorzugsweise eine Haftung, die einer Zugschälkraft von mehr als 5 N/cm, insbesondere mehr als 10 N/cm nach FINAT (Abzug 90° zur Probenebene) entspricht.

Auf einen Primer kann dabei völlig verzichtet werden, und zwar selbst wenn die Einbettfolie an der Grenzfläche mit der Zinn-, Kupfer- oder Silber-haltigen Schicht aus einer sogenannten "fast-cure"-EVA-Folie besteht, also einer EVA-Folie, die zur Vollvernetzung nur einen Bruchteil der Prozesszeit einer herkömmlichen "standard-cure"-EVA-Folie benötigt.

Die Einbettfolie, also insbesondere EVA-, PVB-, Polyolefin- oder Silikon-Folie kann zum Laminieren einer weiteren Glasscheibe verwendet werden, sodass, wenn das Substrat des photovoltaischen Moduls aus Glas besteht, ein Glas-Glas-Laminat entsteht, oder zum Laminieren einer oder mehrerer weiterer Kunststofffolien, sodass, wenn das Substrat aus Glas besteht, ein Glas-Folie-Laminat gebildet wird, wobei diese weitere Folie oder Folien dem Schutz des photovoltaischen Moduls gegenüber der Atmosphäre dienen, also als mechanischer Schutz oder Schutz vor Wasserdampf, Licht und dergleichen.

Die Kunststofffolie kann z. B. aus einem Polykondensat, wie Polyethylenterephthalat (PET) bestehen oder einem fluorhaltigen Kohlenwasserstoffpolymer, z. B. Polyvinylfluorid, das z. B. unter der Marke "Tedlar" von der Firma DuPont vertrieben wird.

Die erfindungsgemäße lötbare Kontaktschicht kann zugleich als Schutzschicht für die Reflektorschicht der Rückelektrodenschicht dienen. Für den Fall, dass für die Reflektorschicht Silber, Kupfer oder andere lötbare Materialien oder Kombinationen von Materialien bzw. Legierungen verwendet werden, kann es während des Lötprozesses zu einer vollständigen Vermischung (Legierung) des Lötzinns mit einigen oder allen Schichten der Rückelektrodenschicht und sogar bis in den Halbleiter kommen. Weiterhin erfolgt dadurch ein sehr hoher Energieeintrag in den Halbleiter, die darunterliegende Frontelektrodenschicht sowie das Substrat. Statt des Lötzinns können auch andere Metallschichten auf der von der Halbleiterschicht abgewandten Seite der metallischen Reflektorschicht mit der metallischen Reflektorschicht legieren. Dies führt zu einer Vielzahl an Fehlern, wie Kurzschlüssen, Schichtdelaminationen, Substratbeschädigungen wie Risse, Ausmuschelungen usw. und dadurch zu einem erhöhten Anteil an Ausschuss bzw. Modulen mit reduzierter Qualität.

Das Auftreten von Lötfehlern bedingt durch das Legieren der Schichten der Rückelektrodenschicht bis hin zur Halbleiterschicht und dem daraus resultierenden hohen Energieeintrag in die Halbleiterschicht, die Frontelektrodenschicht und das Substrat kann erfindungsgemäß dadurch entgegengetreten werden, dass zwischen der Kontaktschicht und der metallischen Reflektorschicht eine Sperrschicht aus einem mit dem Lot und/oder der metallischen Reflektorschicht legierenden Material vorgesehen ist.

Vorzugsweise besteht die mit dem Lot legierende Sperrschicht aus wenigstens einer Schicht eines der Metalle: Titan, Zirkon, Hafnium, Aluminium, Vanadium, Tantal, Niob, Chrom, Molybdän, Wolfram, Mangan und Eisen oder einer Legierung aus wenigstens zwei dieser Metalle oder einer Legierung wenigstens eines dieser Metalle mit wenigstens einem weiteren Metall mit einem dieser Metalle als Hauptkomponente, bezogen auf das Gewicht. Die Dicke der Sperrschicht beträgt dabei vorzugsweise mindestens 5 nm, insbesondere mindestens 10 nm.

Die nicht mit der metallischen Reflektorschicht legierende Sperrschicht besteht vorzugsweise aus einer elektrisch leitfähigen Metallverbindung. Die Metallverbindung kann beispielsweise ein Carbid, Silicid, Nitrid oder Borid sein. Vorzugsweise werden jedoch Metalloxide für die nicht mit der metallischen Reflektorschicht legierende Sperrschicht verwendet.

Als Metalloxide werden insbesondere Metalloxide eingesetzt, wie sie auch für die transparente Frontelektrodenschicht Verwendung finden. Dabei handelt es sich insbesondere um dotiertes Zinkoxid oder Zinnoxid, beispielsweise mit Aluminium dotiertes Zinkoxid mit Fluor dotiertes Zinnoxid oder Indium-Zinn-Oxid.

Die Dicke der Sperrschicht aus dem nicht mit der Reflektorschicht legierenden Material beträgt vorzugsweise 2 bis 500 nm, insbesondere 20 bis 200 nm.

Durch die Sperrschicht wird gewährleistet, dass beim Löten die Schichten der Rückelektrodenschicht nicht mit dem Lötzinn legieren und so Schädigungen am Halbleiter sowie der Frontelektrodenschicht oder dem Substrat hervorrufen. Eine Leistungseinbuße des Moduls durch den Lötprozess wird damit verhindert.

Zur Herstellung des photovoltaischen Moduls werden auf dem transparenten Substrat die transparente Frontelektrodenschicht, die Halbleiterschicht und die Rückelektrodenschicht als Funktionsschichten abgeschieden, die zur Bildung von Serie geschalteten Zellen durch Trennlinien strukturiert werden.

Die metallische Rückelektrodenschicht kann mit einem Laser strukturiert werden, dessen Licht von der Halbleiterschicht absorbiert wird. Durch den Laserstrahl verdampft das im Laserbrennfleck liegende Halbleitermaterial, wodurch die Rückelektrodenschicht im Bereich des Brennflecks abgesprengt wird. Falls das Material der Rückelektrodenschicht jedoch nicht völlig abgesprengt wird und Flitter und dergleichen metallisches Material haften bleibt, können in der Trennlinie zwischen der Rück- und der Frontelektrodenschicht Kurzschlüsse und damit Leistungseinbußen des Moduls auftreten.

Wenn die nicht mit der metallischen Reflektorschicht legierende Sperrschicht aus einer Metallverbindung, also insbesondere einem Metalloxid, wie Zink- und/oder Zinnoxid besteht, wird jedoch der Rückelektrodenschicht für die Laserstrukturierung eine solche Sprödigkeit verliehen, dass der Energieeintrag des Lasers in die Halbleiterschicht des Moduls zu einer vollständigen Absprengung der darüber liegenden Elektrodenschicht führt. Kurzschlüsse durch nicht abgesprengte Flitter oder dergleichen Teile aus metallischem Reflektorschichtmaterial in den Trennlinien sind dadurch verhindert.

Zur Strukturierung der Rückelektrodenschicht wird vorzugsweise ein Laser verwendet, der Laserlicht im sichtbaren Bereich emitiert, beispielsweise ein Neodym dotierter Festkörperlaser, insbesondere ein Neodym dotiertes Yttrium-Vanadat-Laser (Nd:YVO₄-Laser) oder Neodym dotierter Yttrium-Aluminium-Granat-Laser (Nd:YAG-Laser) mit einem Laserlicht der zweiten harmonischen Wellenlänge von 532 nm.

Die Strukturierung der Rückelektrodenschicht wird vorzugsweise mit gepulstem Laserbetrieb durchgeführt, beispielsweise mit einem Güte-Schalter (Q-switch-Betrieb). Das heißt, der Laser ist vorzugsweise CW betrieben und gütegeschaltet. Die Laserspots können dabei mit Überlappung unmittelbar aneinander gesetzt werden. Die Laserstrukturierung der Rückelektrodenschicht kann jedoch beispielsweise auch mit der dritten harmonischen Wellenlänge von 355 nm des Neodym dotierten Festkörperlasers durchgeführt werden oder mit dessen Grundwelle von 1064 nm.

Beispielsweise kann die Laserstrahlung mit einer Wellenlänge von 1064 nm durch das transparente Substrat auf die Frontelektrodenschicht gerichtet werden, die sich dadurch thermisch so aufheizt, dass die darüber liegende Halbleiterschicht zusammen mit der Rückelektrodenschicht thermisch entfernt werden und damit eine Strukturierung der Rückelektrodenschicht erfolgt.

Statt Neodym dotierter Laser können auch andere im Infrarot- oder sichbaren Bereich emittierende Laser eingesetzt werden, beispielsweise mit Ytterbium dotierte Laser mit einer Grundwellenlänge von 1070 nm und zwar vorzugsweise mit einer Frequenzverdoppelung oder -verdreifachung der Grundwellenlänge.

Zwar werden bei der Strukturierung der Rückelektrodenschicht zusätzliche Trennlinien in der Halbleiterschicht gebildet, diese wirken sich jedoch auf die Leistung des photovoltaischen Moduls praktisch nicht aus.

Zur Strukturierung der Rückelektrodenschicht kann der Laserstrahl direkt auf die Rückelektrodenschicht gerichtet werden. Vorzugsweise erfolgt die Strukturierung der Rückelektrodenschicht jedoch mit einem Laserstrahl, der durch das transparente Substrat hindurch auf die Halbleiterschicht gerichtet wird.

Die Beschichtung der Halbleiterschicht mit der Rückelektrodenschicht erfolgt vorzugsweise durch Sputtern.

Dabei können alle Teilschichten der Rückelektrodenschicht durch Sputtern auf die Halbleiterschicht aufgebracht werden, also die metallische Reflektorschicht, die Sperrschicht oder Sperrschichten, gegebenenfalls weitere Schichten bis zur letzten die Rückelektrodenschicht an der von der Halbleiterschicht abgewandten Seite abschließenden Kontaktschicht. Damit kann die Rückelektrodenschicht im Durchlaufverfahren, ohne das Vakuum beim Sputtern unterbrechen zu müssen, hergestellt werden.

Nachstehend ist die Erfindung anhand der beigefügten Zeichnung beispielhaft näher erläutert. Darin zeigen jeweils schematisch:
Figur 1 einen Querschnitt durch einen Teil eines photovoltaischen Dünnschichtmoduls;
Figur 2 den Schichtaufbau auf der Halbleiterschicht des Moduls nach Figur 1 in vergrößerter Wiedergabe; und
Figur 3 einen Längsschnitt durch eine Solarzelle des photovoltaischen Moduls vor der Befestigung des Kontaktbandes durch Löten;
Figur 4 einen Querschnitt durch einen Teil eines modifizierten photovoltaischen Dünnschichtmoduls; und
Figur 5 einen Schichtaufbau der Rückelektrodenschicht des Moduls nach Figur 4 in vergrößerter Wiedergabe.

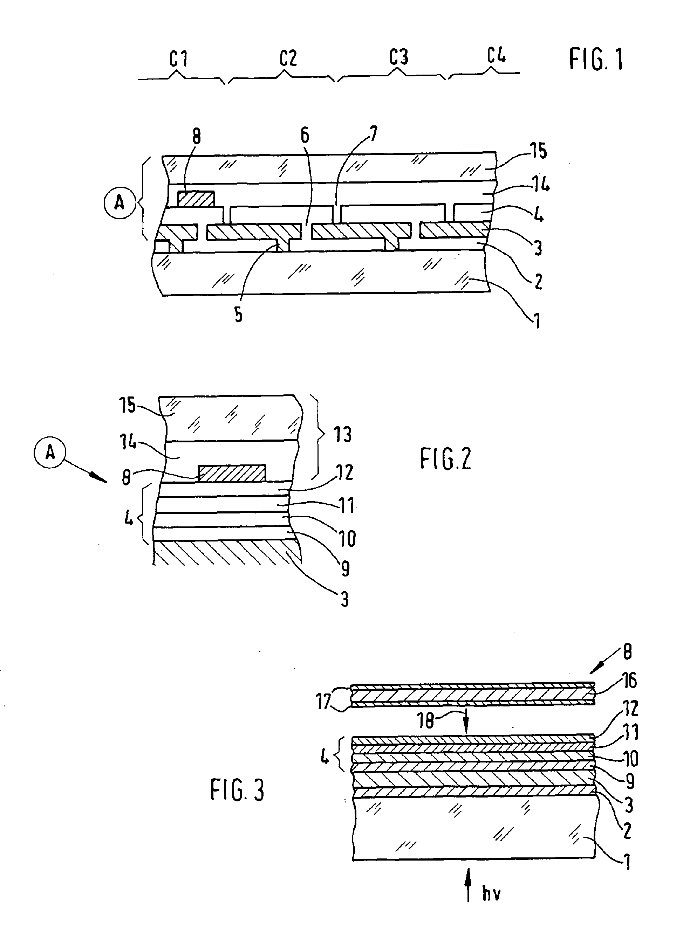

Gemäß Figur 1 ist auf einem großflächigen transparenten Substrat 1, beispielsweise einer Glasscheibe, eine Frontelektrodenschicht 2, z. B. aus dotiertem Zinnoxid vorgesehen, auf der eine Halbleiterschicht 3, z. B. aus amorphem Silizium aufgebracht ist. Auf die Silizium-Halbleiterschicht 3 ist die Rückelektrodenschicht 4 aufgetragen.

Das Modul besteht aus Einzelzellen C1, C2, C3, C4, die serienverschaltet sind. Dazu ist die Frontelektrodenschicht 2 durch die Trennlinien 5, die Silizium-Halbleiterschicht 3 durch die Trennlinien 6 und die Rückelektrodenschicht 4 durch die Trennlinien 7 strukturiert. Die streifenförmigen Einzelzellen C1, C2, C3, C4 verlaufen senkrecht zur Stromflussrichtung. Die Zelle C1 ist zur Stromabnahme ausgebildet. Dazu ist an die Rückelektrodenschicht 4 der Zelle C1 ein Kontaktbändchen 8 angelötet.

Die Rückelektrodenschicht 4 besteht gemäß Figur 2 aus einer der Halbleiterschicht 3 zugewandten Metalloxid-Schicht 9, z. B. aus Zinkoxid, einer darauf aufgebrachten Metallschicht 10, z. B. aus Aluminium, Kupfer, Silber und/oder Chrom, die zugleich die Reflektorschicht bildet, einer metallischen Sperrschicht 11 aus einem nicht mit dem Lot 17 (Figur 3) legierenden Material und der Kontaktschicht 12 z.B. aus oxidiertem Zinn.

Auf der Rückelektrodenschicht 4 ist ein Rückflächenverkapselungsmaterial 13 auflaminiert. Das Rückflächenverkapselungsmaterial 13 besteht aus einer Einbettfolie 14, beispielsweise einer EVA-, PVB-, Polyolefin- oder Silikon-Einbettfolie, mit der auf das photovoltaische Modul eine Schutzschicht 15, z. B. eine Glasscheibe und/oder eine oder weitere Folien z. B. aus PET auflaminiert werden.

Gemäß Figur 3 wird das Kontaktband 8, das an der Rückelektrodenschicht 4 der Solarzelle 1 durch Lötverbindung befestigt werden soll, durch ein Metallband 16 z.B. aus Kupfer gebildet, dass auf beiden Seiten, also auf der der Rückelektrodenschicht 4 zugewandten Fügefläche und der gegenüberliegenden Fläche mit einem Lot 17 beschichtet ist.

Zum Löten wird das Kontaktband 8 gemäß dem Pfeil 18 mit der Kontaktschicht 12 der Solarzelle in Berührung gebracht, wobei das Kontaktband 8 induktiv erhitzt wird.

Wenn die Halbleiterschicht 3 durch einen kristallinen Halbleiter-Wafer gebildet wird, weist die Rückelektrodenschicht einen entsprechend geänderten Aufbau auf.

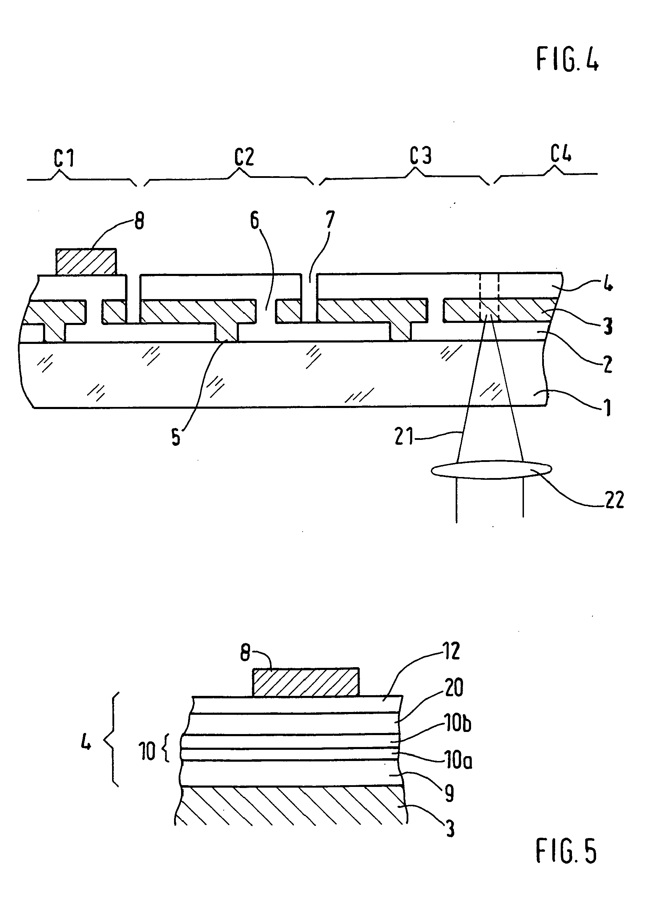

Das Dünnschichtmodul nach Figur 4 unterscheidet sich von dem nach Figur 1 im Wesentlichen nur dadurch, dass die Rückseitenverkapselung weggelassen ist und sich die Trennlinie 7 in der Rückelektrodenschicht 4 auch durch die Halbleiterschicht 3 erstreckt.

Die Rückelektrodenschicht 4 besteht gemäß Figur 5 aus einer der Halbleiterschicht 3 zugewandten Metalloxid-Schicht 9, z. B. aus Zinkoxid, einer darauf aufgebrachten Reflektorschicht 10, z. B. aus einer Silber-Teilschicht 10a und einer Aluminium-Teilschicht 10b, einer spröden, elektrisch leitfähigen Schicht 20, z.B. aus einem Metalloxid, beispielsweise Zinkoxid und einer Kontaktschicht 12, z. B. aus oxidiertem Zinn oder aus Kupfer, an die das Kontaktbändchen 8 angelötet wird.

Wie in Figur 4 rechts dargestellt ist, wird zur Bildung der Trennlinie 7 in der Rückelektrodenschicht 4 ein Laser verwendet, dessen Laserstrahl 21 mit einer Linse 22 durch das transparente Substrat 1 und die Frontelektrodenschicht 2 auf die Halbleiterschicht 3 fokussiert ist. Die Laserstrahlung, deren Wellenlänge im Spektralbereich starker Absorption der Halbleiterschicht 3 liegt, beispielsweise bei 532 nm, heizt damit die Halbleiterschicht 3 auf, und zwar so, dass diese verdampft, jedenfalls so erhitzt wird, dass die darüber liegende Rückelektrodenschicht 4 in diesem Bereich abgesprengt und damit die Trennlinie 7 gebildet wird. Zwar erstreckt sich die Trennlinie 7 in der Rückelektrodenschicht 4 damit auch in die Halbleiterschicht 3. Die Leistung des photovoltaischen Moduls wird dadurch aber praktisch nicht beeinflusst.

Die nachstehenden Beispiele dienen der weiteren Erläuterung der Erfindung.

### Beispiel 1

Auf ein photovoltaisches Modul mit einer Rückelektrodenschicht aus Zinkoxid (Schichtdicke 90nm), einer Aluminiumschicht (250nm), einer Nickel-Vanadium-Schicht (50nm), auf der eine oberflächlich oxidierte Zinn(Sn)-Schicht (20nm) durch Sputtern aufgebracht worden ist, wird ein Kontaktbändchen bestehend aus einem verzinnten Kupferbändchen gelötet. Anschließend wird eine fast-cure EVA-Einbettfolie aufgebracht.

Die Zugschälkraft zum Ablösen der Einbettfolie vom photovoltaischen Modul wird nach einer FINAT-Testmethode (90° Abzugswinkel) ermittelt und zwar nach einem Feuchte-Hitze-Test laut IEC 61646 jedoch nach einer erhöhten Zeitspanne von 2300 Stunden. Ferner wird die Lötbarkeit des Kontaktbändchens ermittelt.

### Vergleichsbeispiel 2

Das Beispiel 1 wurde wiederholt, außer dass die Zinn-Schicht weggelassen wurde. Anstelle dessen wurde vor der Laminierung ein Primer aufgebracht.

### Vergleichsbeispiel 3

Das Vergleichsbeispiel 2 wurde wiederholt, außer dass hierbei sowohl die Zinn-Schicht als auch der Primer weggelassen wurden.

| | abschließende Schicht | Zugschälkraft | Lötbarkeit |
|---|---|---|---|
| Bsp. 1 | Sn ohne Primer | 17N/cm | ja |
| Vgl.-Bsp. 2 | NiV mit Primer | 1N/cm | ja |
| Vgl.-Bsp. 3 | NiV ohne Primer | 1N/cm | ja |

### Beispiele 2 bis 4

Es wurden Dünnschichtsolarzellen verwendet, die an der abschließenden Nickel-Vanadium-Schicht der Rückelektrodenschicht durch Magnetron-Sputtern mit einer Zinnschicht mit Schichtdicke von ≤ 7nm, 20nm bzw. 35nm versehen worden sind. Bei Verwendung eines Kontaktbandes mit einer Beschichtung aus einem bleifreien Lot ergaben sich nach unterschiedlichen Lötzeiten folgende Abzugswerte:

| | | | Lötzeit / s | | |
|---|---|---|---|---|---|
| | Sn-Dicke | 0,7s | 0,9s | 1,1s | 1,3s |

| | | Abzugswerte | | | |
|---|---|---|---|---|---|
| Bsp. 2 Bsp. 3 Bsp. 4 | ≤ 7nm 20 nm 35nm | <1N 5,5N 10,3N | <1N 6,3N 11,1N | <1N 7,4N 12,5N | <1N 8,4N 11,3N |

Es ist ersichtlich, dass bei einer Schichtdicke der Zinn-Schicht von 20 bzw. 35 nm hohe Abzugswerte des Kontaktbandes erhalten werden, und zwar bei einer Schichtdicke von 35 nm bereits nach einer sehr kurzen Lötzeit von 0,7 Sekunden.

## Patentansprüche

1. Photovoltaisches Modul mit einer Rückelektrodenschicht (4), an der Kontaktbänder (8) durch eine Lötverbindung befestigt sind, **dadurch gekennzeichnet, dass** die Rückelektrodenschicht (4) an ihrer den Kontaktbändern (8) zugewandten Außenseite mit einer Zinn-, Kupfer- und/oder Silber-haltigen Kontaktschicht (12) versehen ist.

2. Photovoltaisches Modul nach Anspruch 1, **dadurch gekennzeichnet, dass** die Schichtdicke der Kontaktschicht (12) 1 bis 500 nm beträgt.

3. Photovoltaisches Modul nach Anspruch 1 oder 2, **dadurch gekennzeichnet, dass** die Schichtdicke der Kontaktschicht (12) 10 bis 100 nm beträgt.

4. Photovoltaisches Modul nach Anspruch 1, **dadurch gekennzeichnet, dass** die Zinn-, Kupfer- oder Silber-haltige Kontaktschicht (12) aus einer Legierung dieser Metalle mit wenigstens einen weiteren Metall besteht.

5. Photovoltaisches Modul nach Anspruch 1, **dadurch gekennzeichnet, dass** die Kontaktschicht (12) eine Zinn-haltige Schicht ist, die aus zumindest teilweise oxidiertem Zinn und/oder einer zumindest teilweise oxidierten Zinnlegierung besteht.

6. Photovoltaisches Modul nach Anspruch 1, **dadurch gekennzeichnet, dass** die Kontaktbänder (8) mit einem Lot (17) mit einer Schichtdicke von 5 bis 50 µm beschichtet sind.

7. Photovoltaisches Modul nach Anspruch 1 oder 6, **dadurch gekennzeichnet, dass** das Lot (17) Lötzinn ist.

8. Photovoltaisches Modul nach einem der vorstehenden Ansprüche, **dadurch gekennzeichnet, dass** die Rückelektrodenschicht (4) eine metallische Reflektorschicht (10) aufweist und eine Sperrschicht (11, 20) aus einem nicht mit dem Lot (17) und/oder der metallischen Reflektorschicht (10) legierenden Material zwischen der Kontaktschicht (12) und der metallischen Reflektorschicht (10) vorgesehen ist.

9. Photovoltaisches Modul nach Anspruch 8, **dadurch gekennzeichnet, dass** die nicht mit dem Lot (17) legierende Sperrschicht (11) an der dem Kontaktband (8) abgewandten Seite der Kontaktschicht (12) in der Rückelektrodenschicht (4) vorgesehen ist.

10. Photovoltaisches Modul nach Anspruch 8 oder 9, **dadurch gekennzeichnet, dass** die nicht mit dem Lot (17) legierende Sperrschicht (11) eine metallische Sperrschicht ist und aus wenigstens einer Schicht eines der Metalle: Titan, Zirkon, Hafnium, Aluminium, Vanadium, Tantal, Niob, Chrom, Molybdän, Wolfram, Mangan, Eisen, Nickel und Tellur oder einer Legierung aus wenigstens zwei dieser Metalle oder einer Legierung eines dieser Metalle mit wenigstens einem weiteren Metall mit einem dieser Metalle als Hauptkomponente besteht.

11. Photovoltaisches Modul nach Anspruch 10, **dadurch gekennzeichnet, dass** die Dicke der metallischen Sperrschicht (11) mindestens 5 nm beträgt.

12. Photovoltaisches Modul nach Anspruch 8, **dadurch gekennzeichnet, dass** die nicht mit der metallischen Reflektorschicht (10) legierende Sperrschicht (20) aus einer elektrisch leitfähigen Metallverbindung besteht.

13. Photovoltaisches Modul nach Anspruch 12, **dadurch gekennzeichnet, dass** die aus einer elektrisch leitfähigen Metallverbindung bestehende Sperrschicht (20) eine Dicke von 2 bis 500 nm aufweist.

14. Photovoltaisches Modul nach Anspruch 12, **dadurch gekennzeichnet, dass** die elektrisch leitfähige Metallverbindung ein Metalloxid ist.

15. Photovoltaisches Modul nach Anspruch 14, **dadurch gekennzeichnet, dass** das Metalloxid Zinkoxid und/oder Zinnoxid ist.

16. Photovoltaisches Modul nach einem der Ansprüche 8 bis 15, **dadurch gekennzeichnet, dass** die metallische Reflektorschicht (10) eine Schichtdicke von 50 bis 500 nm aufweist.

17. Photovoltaisches Modul nach einem der Ansprüche 8 bis 16, **dadurch gekennzeichnet, dass** die metallische Reflektorschicht (10) aus wenigstens einer Schicht (11, 12) aus Silber, Aluminium, Kupfer und/oder Chrom oder einer Legierung dieser Metalle besteht.

18. Photovoltaisches Modul nach einem der vorstehenden Ansprüche, **dadurch gekennzeichnet, dass** es ein Rückseitenverkapselungsmaterial (13) aufweist, das die Rückelektrodenschicht (4) mit den Kontaktbändern (8) abdeckt.

19. Photovoltaisches Modul nach Anspruch 1, **dadurch gekennzeichnet, dass** das Rückflächenverkapselungsmaterial (13) zumindest an der Grenzfläche mit der Kontaktschicht (12) aus einer Einbettfolie (14) gebildet ist.

20. Photovoltaisches Modul nach Anspruch 19, **dadurch gekennzeichnet, dass** die Einbettfolie (14) eine Folie aus EVA (Ethylenvinylacetat), PVB (Polyvinylbutyral), Polyolefin oder Silikon ist.

21. Photovoltaisches Modul nach Anspruch 19 oder 20,**dadurch gekennzeichnet, dass** das Rückflächenverkapselungsmaterial (13) außer der Einbettfolie (14) eine Schutzschicht (15) aufweist, die auf der der Rückelektrodenschicht gegenüberliegenden Seite der Einbettfolie (14) angeordnet ist.

22. Photovoltaisches Modul nach Anspruch 21, **dadurch gekennzeichnet, dass** die Schutzschicht (15) aus Glas und/oder wenigstens einer Kunststofffolie besteht.

23. Photovoltaisches Modul nach Anspruch 22, **dadurch gekennzeichnet, dass** die Kunststofffolie aus einem Polykondensat oder einem fluorhaltigen Kohlenwasserstoffpolymer besteht.

24. Verfahren zum Befestigen der Kontaktbänder (8) an der Rückelektrodenschicht (4) eines photovoltaischen Moduls durch eine Lötverbindung, **dadurch gekennzeichnet, dass** die Rückelektrodenschicht (4) an ihrer Außenseite mit einer Zinn-, Kupfer- und/oder Silber-haltigen Kontaktschicht (12) versehen und das zumindest an der Fügefläche mit Lot (17) versehene Kontaktband (8) durch Löten mit der Kontaktschicht (12) verbunden wird.

25. Verfahren nach Anspruch 24, **dadurch gekennzeichnet, dass** die Kontaktschicht (12) und/oder die Sperrschicht (11) durch physikalische Gasphasenabscheidung abgeschieden wird.

26. Verfahren nach Anspruch 25, **dadurch gekennzeichnet, dass** als physikalisches Gasphasenabscheidungsverfahren das Magnetron-Sputtern angewendet wird.

27. Verfahren nach Anspruch 24, **dadurch gekennzeichnet, dass** ein induktives Lötverfahren verwendet wird.

28. Verfahren nach Anspruch 24 oder 27, **dadurch gekennzeichnet, dass** ein Kontaktband (8) verwendet wird, das zumindest an der Fügefläche mit einem Lot (17) mit einer Schichtdicke von 5 bis 50 µm versehen ist.

29. Verfahren nach Anspruch 24 oder 28, **dadurch gekennzeichnet, dass** ein mit einem bleifreien Lot (17) versehenes Kontaktband (8) verwendet wird.
